# EUROPÄISCHE PATENTSCHRIFT

(11) **EP 1 605 269 B1**
(45) Veröffentlichungstag und Bekanntmachung des Hinweises auf die Patenterteilung: **18.08.2010**
(21) Anmeldenummer: 05011556.7
(22) Anmeldetag: 28.05.2005
(51) Int. Cl.: G01R 11/04

(54) **Zählerplatz**
Mounting platform for utility meter
Montage pour un compteur de service

(30) Priorität: 08.06.2004 DE 102004027754; 18.11.2004 DE 102004055820
(43) Veröffentlichungstag der Anmeldung: 14.12.2005
(73) Patentinhaber: Hager Electro GmbH & Co. KG, 66440 Blieskastel (DE)
(72) Erfinder: Clemens, Guntram, Dr.-Ing., 90409 Nürnberg (DE); Kelaiditis, Konstantin, Dr.-Ing., 66386 St. Ingbert (DE); Gros, Bernhard, 57450 Seingbouse (FR); Zimmermann, Michael, 66399 Mandelbachtal (DE)
(74) Vertreter: Bernhardt, Reinold

(56) Entgegenhaltungen:
- EP-A- 0 834 744
- EP-A- 1 544 627
- DE-A1- 10 052 998
- US-A- 5 775 942

## Beschreibung

Die Erfindung betrifft einen Zählerplatz für einen Stromzähler, der Einrichtungen zur Befestigung des Stromzählers an dem Zählerplatz in einer für die Aufnahme des Zählers vorgesehenen, von der Betriebsposition des Stromzählers auf dem Zählerplatz entfernten Parkposition aufweist.

Um Zählerplätze außer Betrieb zu setzen, werden herkömmlich, sofern keine Schalter in den dem Zählerplatz zugeführten oder vom Zählerplatz weggeführten Leitungen vorgesehen sind, zugeführte oder weggeführte Leitungen abgeklemmt und isoliert.

In einem Zählerplatz für einen elektronischen Stromzähler, wie er aus der DE 100 52 998 A1 hervorgeht, wird der Stromzähler auf den Zählerplatz senkrecht aufgesetzt und parallel zu einer Zählertragplatte unter mechanischer und elektrischer Ankopplung am Zählerplatz und Verhakung des Stromzählers mit der Zählertragplatte verschoben. Auch um einen solchen Zählerplatz außer Betrieb zu setzen, könnten Leitungen abgeklemmt und der Stromzähler am Zählerplatz in einer Betriebslage belassen werden.

Aus der EP 0 834 744 A2 geht eine Steckklemme für Stromzähler hervor, mit der der Stromzähler in einer Betriebsposition und in einer weiteren Position, in der Stromzähler von der Steckklemme abgenommen oder auf sie aufgesetzt wird, gehalten werden kann.

Der vorliegenden Erfindung liegt die Aufgabe zugrunde, insbesondere einen Zählerplatz der eingangs genannten Art derart weiterzuentwickeln, dass der Zählerplatz nach seiner Stilllegung mit geringem Aufwand wieder in Betrieb genommen werden kann.

Der diese Aufgabe lösende Zählerplatz nach der Erfindung ist dadurch gekennzeichnet, dass Einrichtungen zur Arretierung des Stromzählers in der Parkposition durch ein Vorhänge- oder Steckschloss und/oder zur Plombierung des Stromzählers in der Parkposition vorgesehen sind.

Vorteilhaft ist der Zähler so an einem außer Betrieb genommenen Zählerplatz z.B. gegen Diebstahl gesichert, kann am Zählerplatz verbleiben und steht bei Wiederinbetriebnahme unmittelbar zur Verfügung.

In einer bevorzugten Ausführungsform der Erfindung umfasst der Zählerplatz einen Adapter, über welchen der Stromzähler an einen anderen, zur Aufnahme eines anderen Stromzählers vorgesehenen Zählerplatz elektrisch und mechanisch koppelbar ist. Über den Adapter lässt sich z.B. ein elektronischer Stromzähler an einen Zählerplatz koppeln, der zur Aufnahme herkömmlicher, über ein Zählerkreuz zu befestigender elektromechanischer Zähler vorgesehen ist.

In der bevorzugten Ausführungsform der Erfindung ist der Stromzähler sowohl in der Betriebsposition als auch in der Parkposition an den Zählerplatz mechanisch durch Hakenelemente, welche auf der dem Zählerplatz zugewandten Seite des Stromzählergehäuses angeordnet sind, gekoppelt.

Zweckmäßig weisen die Einrichtungen zur Befestigung des Stromzählers Halteelemente auf, die sich wenigstens teilweise aus ihrer Betriebsstellung, in der sie den Stromzähler in der Parkposition festhalten, entfernen lassen. Vorteilhaft können die entfernten Halteelemente die Überführung des Stromzählers von der Parkposition in die Betriebsposition nicht behindern. Die Parkposition kann so platzsparend nahe bei der Betriebsposition angeordnet sein.

Zweckmäßig stehen die Halteelemente von einer Zählertragplatte vor. Während es denkbar wäre, aus einer Zählertragplatte, z.B. teleskopartig, ausfahrbare, säulenartige Halter für den Stromzähler vorzusehen, umfassen die Halteelemente in der bevorzugten Ausführungsform der Erfindung einen von der Zählertragplatte vorstehenden Steg. Solche Stege können den Zugang zu den stromführenden Teilen erschweren oder verhindern.

Dieser Haltesteg kann mit abklappbaren Halteleisten versehen sein, wobei die Halteleisten Öffnungen für den Eingriff der genannten Hakenelemente am Gehäuse des Stromzählers aufweisen. Die Halteleisten können mit den von der Zöhlertragplatte vorstehenden Stegen über Filmscharniere verbunden sein.

In weiterer Ausgestaltung der Erfindung sind am Zählerplatz Einrichtungen zur Befestigung der Halter entfernt von ihrer Betriebsstellung vorgesehen. Werden die Halter bei einer Außerbetriebnahme des Zählerplatzes benötigt, stehen sie unmittelbar am Zählerplatz zur Verfügung.

In einer weiteren Ausführungsform der Erfindung können die Einrichtungen zur Befestigung des Stromzähler an der Zählertragplatte eine Blindplatte umfassen, welche in einer der Betriebsposition des Zählers entsprechende Position angeordnet ist.

Die Erfindung wird nachfolgend anhand von Ausführungsbeispielen und der beiliegenden, sich auf diese Ausführungsbeispiele beziehenden Zeichnungen näher erläutert. Es zeigen:
- Fig. 1: einen Zählerplatz bzw. Zählerplatzadapter gemäß einem ersten Ausführungsbeispiel für die vorliegende Erfindung,
- Fig. 2: ein zur Befestigung des Stromzählers an dem Zählerplatz von Fig. 1 in einer Parkposition dienendes Halteelement in drei verschiedenen Ansichten,
- Fig. 3: das Halteelement von Fig. 2 mit einem auf dem Halteelement zu befestigenden Stromzähler, und
- Fig. 4 bis 9: weitere Ausführungsbeispiele für Zählerplätze bzw. Zöhlerplatzadapter nach der vorliegenden Erfindung.

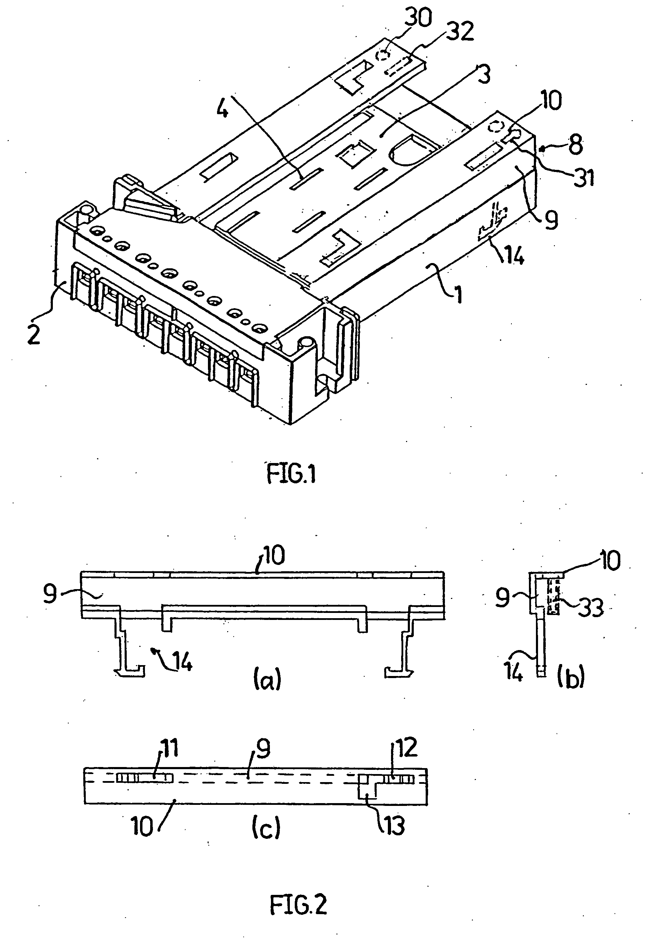

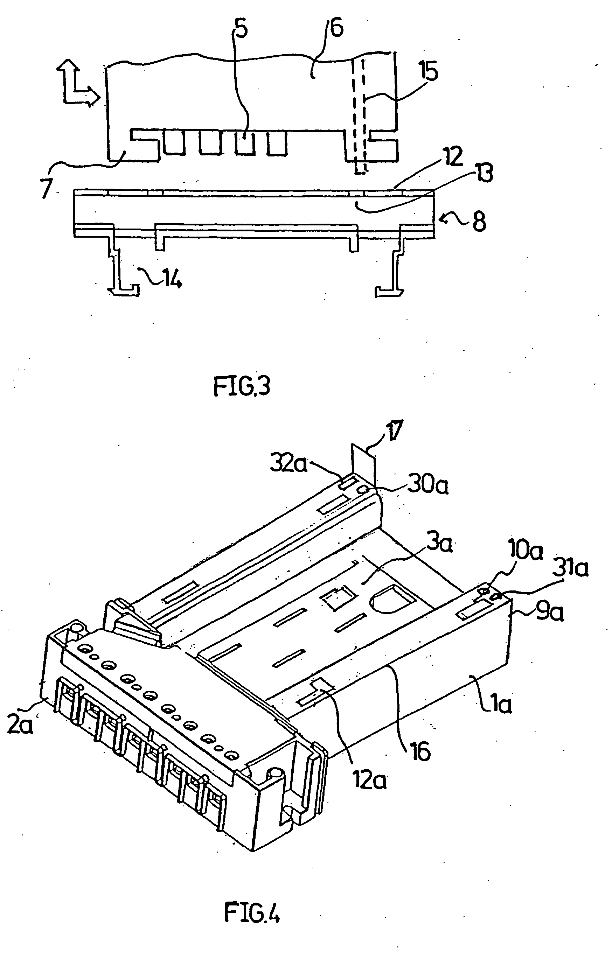

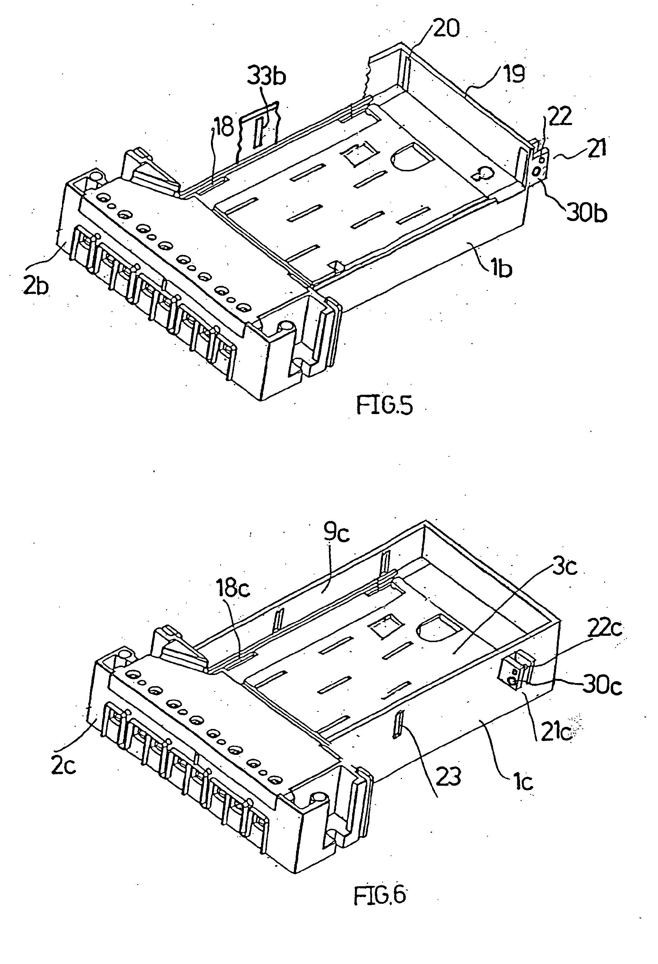

Fig. 1 zeigt einen Adapter mit einem Kastenteil 1 und einem Anschlussleistenteil 2. Ein solcher Adapter ist in der DE 10 2004 025 605.5 beschrieben. Der Kastenteil 1 weist eine Zählertragplatte 3 auf, in der Schlitze 4 für den Eingriff von Kontaktelementen 5 vorgesehen sind, die vom Gehäuse eines in Fig. 3 gezeigten Stromzählers 6 in Richtung zu der Zählertragplatte 3 vorstehen. An dem Gehäuse des Stromzählers 6 sind ferner vier Hakenelemente 7 angebracht, welche in am Rand des Kastenteils 1 angeordnete, in den Fig. 5 bis 7 sichtbare Schlitze 18 im Kastenteil 1 eingreifen. Durch senkrechtes Aufsetzen des Stromzählers 6 auf die Zählertragplatte 3 und Verschiebung parallel zur Tragplatte kann der Stromzähler elektrisch und mechanisch an den Adapter gekoppelt werden, wie dies in der DE 10 2004 025 605.5 beschrieben ist.

An einander gegenüberliegenden Vertikalrändern der Zählertragplatte 3 sind an deren Rand auf die Zählertragplatte zwei Halteelemente 8 aufgesteckt, die aus einem senkrecht von der Zählertragplatte 3 vorstehenden Steg 9 und einer eine Halteleiste 10 bildenden Abwinklung von dem Steg 9 bestehen. Die Halteleiste 10 weist schlitzartige Öffnungen 11 und 12 für den Eingriff der Hakenelemente 7 am Gehäuse des Stromzählers 6 auf. Wie Fig. 2 erkennen lässt, ist die Öffnung 12 an einem Ende bei 13 aufgeweitet.

Wie aus Fig. 2 ferner hervorgeht, weist das Halteelement 8 Steckverbindungselemente 14 auf, welche in die für die Aufnahme der Hakenelemente 7 des Stromzählers vorgesehenen Schlitze 18 am Kastenteil 1 des Adapters einführbar und in den Schlitzen einrastbar sind.

Soll eine Außerbetriebnahme erfolgen, so wird der an den Adapter angeschlossene Stromzähler 6 von der Zählertragplatte 3 entfernt. Eine durch die Entfernung des Zählers automatisch wiederhergestellte Überbrückung der Stromphasen wird danach mit Hilfe eines Werkzeugs aufgehoben, wie dies in der DE 10 2004 025 605.5 beschrieben ist.

Zum Parken des Stromzählers 6 an dem Zählerplatz werden nun die Halteelemente 8 auf die Zählertragplatte 3 des Kastenteils 1 aufgesteckt und der Zähler 6, wie dies in Fig. 3 gezeigt ist, auf die Halteleiste 10 der Halteelemente 8 aufgesetzt. Dabei greifen die Hakenelemente 7 in die Öffnungen 11 bzw. 12 ein. Durch Verschiebung parallel zur Zählertragplatte 3 wird der Stromzähler in die Parkposition gebracht. Mit Hilfe eines durch das Zählergehäuse geführten Plombierbolzens 15, welcher in die Aufweitung 13 der Öffnung 12 eingreift, lässt sich der Stromzähler 6 in der Parkstellung arretieren und plombieren. Durch den Stromzähler sind die Zugänge zu den Steckverbindungselementen 14 abgedeckt, so dass sich die Halteelemente 8 nicht mehr entfernen lassen.

Anstelle zweier Halteelemente 8 könnte auch ein einziges, U-förmiges Halteelement vorgesehen sein. Andererseits könnten die Halteelemente 8 selbst mehrere Teile, z.B. zwei Teile, aufweisen.

Für die Halteelemente 8 könnten an dem Kastenteil 1, insbesondere an dessen Unterseite, Einrichtungen zu deren Befestigung während des Betriebs des Zählerplatzes vorgesehen sein. Bei einer Stilllegung des Zählerplatzes ständen die Halteelemente 8 dann unmittelbar am Zählerplatz für die Befestigung des Stromzählers in der Parkstellung zur Verfügung.

Die Arretierung des geparkten Stromzählers könnte auch mit Hilfe eines Vorhängeschlosses erfolgen, dessen Bügel durch eine Öffnung 30 im Halteelement 8 geführt ist. Alternativ oder zusätzlich könnte ein Steckloch 31 für ein an dem Halteelement vorstehendes Steckschloss gebildet sein. Schließlich ist zur Blockierung des Stromzählers auch eine Steckplombe, wie sie in der DE 10 2004 054 887.0 beschrieben ist, verwendbar und durch eine Öffnung 32 in einen Steckkanal 33 einführbar.

In den folgenden Figuren sind gleiche oder gleichwirkende Teile mit derselben Bezugszahl wie in Fig. 1 und 2 bezeichnet, wobei den betreffenden Teilen jeweils der Buchstabe a, b usw. beigefügt ist.

Bei dem Ausführungsbeispiel von Fig. 4 sind vertikale Seitenwände eines Kastenteils 1 a über die Vorderseite einer Zählertragplatte 3a hinaus verlängert. Entsprechende Verlängerungen 9a sind mit Halteleisten 10a jeweils über ein Filmscharnier 16 verbunden.

Die Halteleisten 10a weisen ein abklappbares Endteil 17 auf. An der dem Endteil entgegengesetzten Ende der Halteleiste 10a sind am Gehäuse des Adapters in Fig. 4 nicht sichtbare Stütz- und Rastnasen für die Halteleiste 10a gebildet.

Im Betriebszustand des Zählerplatzes, wenn der Stromzähler auf die Tragplatte 3a aufgesetzt ist, sind die Halteleisten 10a weggeklappt. Bei Stilllegung des Zählerplatzes werden sie in die in Fig. 4 gezeigte Stellung gebracht, wobei die Endteile 17 auf der Zählertragplatte 3a aufsitzen. An dem dem Endteil 17 entgegengesetzten Ende sind die Halteleisten 10a am Gehäuse des Adapters abgestützt. An den Halteleisten 10a lässt sich der Stromzähler 6, wie anhand des vorangehenden Ausführungsbeispiels beschrieben, befestigen.

Abweichend von diesem Ausführungsbeispiel könnte ein Filmscharnier auch zwischen der Verlängerung 9a und der betreffenden Seitenwand des Kastenteils 1 a gebildet sein. Die Halteleisten 10a könnten auch in der weggeklappten Position am Gehäuse des Adapters durch eine Stütznase abgestützt und eine Rastnase festgehalten sein.

Bei dem Ausführungsbeispiel von Fig. 5 sind in einer Verlängerung 19 einer oberen Seitenwand eines Kastenteils 1 b eines Adapters zwei Öffnungen 20 gebildet. In die Öffnungen 20 sind die beiden oberen Hakenelemente 7 des Stromzählers 6 in einer Parkposition des Stromzählers einhakbar. Zwei vorstehende Laschen 21 mit einer Durchgangsbohrung 22 dienen der Plombierung des Stromzählers in dieser Parkposition. In die Durchgangsbohrung 22 ist ein plombierbarer Stift einsetzbar. Alternativ könnten die Laschen 21 hinter dem Hakenelement 7 einrasten und durch die Bohrung 22 direkt ein Plombierdraht gelegt werden. Die Verlängerung 19 könnte über ein Filmscharnier abklappbar sein. Auch die vertikalen Seitenwände des Kastenteils 1 b sind vorteilhaft unter Bildung von Abdeckungen verlängert.

Das Bezugszeichen 33b weist auf eine Stecköffnung für eine seitlich einzuschiebende Steckplombe hin, welche ein Hakenelement 7 des Stromzählers hintergreift und eine Verschiebung des geparkten Stromzählers verhindert.

Bei dem Ausführungsbeispiel von Fig. 6 sind in einander gegenüberliegenden Seitenwandverlängerungen 9c Öffnungen 23 für die vier Hakenelemente 7 des Stromzählers 6 vorgesehen, in welche der Stromzähler quer zu der Richtung, in welcher er zwecks Anschluss an den Adapter auf der Zählertragplatte 3c verschiebbar ist, eingehängt werden kann. Laschen 21 c mit einer Durchgangsbohrung 22c dienen der Plombierung des Stromzählers.

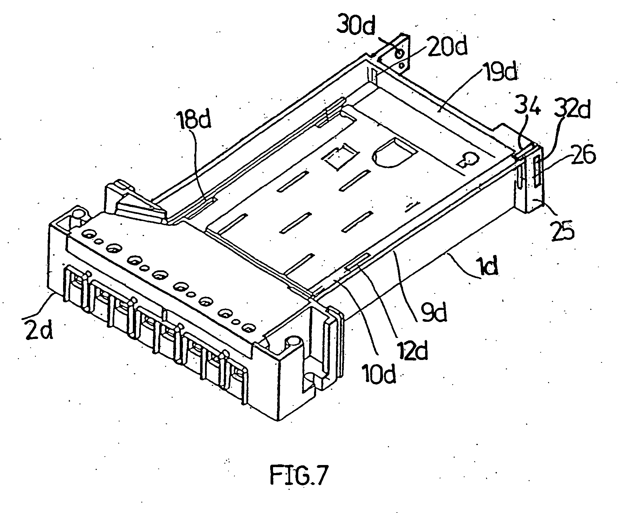

Bei dem Ausführungsbeispiel von Fig. 7 ist an einer Seite eines Kastenteils 1 a an einer Verlängerung 9d der vertikalen Kastenteilseitenwand eine Halteleiste 10d mit einer Öffnung 24 gebildet. Eine obere Seitenwand des Kastenteils 1 d weist eine seitliche Verlängerung 25 mit einer Öffnung 26 auf. In einer weiteren Verlängerung 19d der oberen Seitenwand des Kastenteils 1 d ist eine Öffnung 20d gebildet.

In der Parkstellung greifen die beiden oberen Elemente 7 des Stromzählergehäuses 6 in die Öffnungen 20d und 26 ein. Eines der beiden unteren Hakenelemente des Stromzählers ist in der Öffnung 24 verhakt. Das vierte Hakenelement der Hakenelemente 7 des Stromzählers steht frei.

Das Bezugszeichen 32d weist auf eine Stecköffnung für eine Steckplombe hin, welche ein in einen Schlitz 34 eingreifendes Hakenelement 7 des Stromzählers hintergreift und den Stromzähler blockiert.

Die Öffnung 24 könnte eine der Aufweitung 13 entsprechende Aufweitung zur Plombierung aufweisen oder an den Öffnungen 20d oder 26 könnten den Laschen 21 entsprechende Laschen vorgesehen sein.

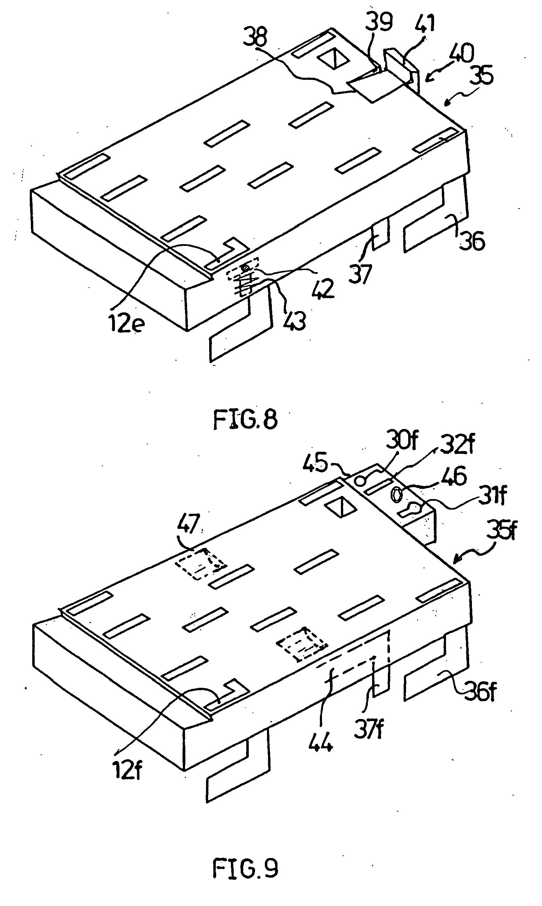

Es wird nun auf Fig. 8 Bezug genommen, wo eine Platte 35 gezeigt ist, welche sich anstelle des Stromzählers auf die Zählertragplatte 3 aufsetzen lässt. Entsprechend weist die Platte 35 vier den Hakenelementen 7 des Stromzählers 6 entsprechende Hakenelemente 36 auf. Ferner stehen von der Platte 35 den Kontaktelementen 5 des Stromzählers 6 in der Form entsprechende Mitnehmerelemente 37 vor, durch welche sich in dem Adapter 1 angeordnete Überbrückungsteile über eine unter der Zählertragplatte angeordneten Mitnehmerplatte verschieben lassen. Zur Verschiebung der Mitnehmerplatte genügt ggf. ein einziges solches Mitnehmerelement 37. Andererseits könnten die Elemente 37 auch entfallen, wenn in anderer Weise, z.B. mittels eines Werkzeug, für eine Aufhebung oder Herstellung der Überbrückung gesorgt wird.

An die Platte 35 ist bei 38 über ein Filmscharnier ein in einer Ausnehmung 39 verschwenkbares, T-förmiges Sperrelement angeformt. Beim Aufsetzen der Platte 35 auf eine Zählertragplatte verschiebt sich ein hakenförmiger Abschnitt 41 des Sperrelements 40 derart relativ zur Platte 35 nach oben, so dass der auf die Platte 35 aufgesetzte und parallel dazu verschobene Stromzähler 6 durch den Abschnitt 41 blockiert ist.

Bei 42 ist ein durch eine Feder 43 beaufschlagtes, durch einen Draht plombierbares Drehbefestigungselement zur Arretierung der Platte 35 auf der Zählertragplatte angedeutet. Gegebenenfalls lässt sich das Drehbefestigungselement 42 durch den durch das Stromzählergehäuse hindurchgeführten Plombierbolzen 15 betätigen, durch welchen der Stromzähler seinerseits auf der Platte 35 arretierbar ist.

Es wird nun auf Fig. 9 Bezug genommen, wo eine der Platte 35 ähnliche Platte 35f mit Hakenelementen 36f dargestellt ist.

In dem betreffenden Ausführungsbeispiel sind leitende Mitnehmerelemente 37f entsprechend allen sechs Phasenkontaktelementen 5 des Stromzählers 6 vorgesehen. Die Phasenkontaktelemente 37f sind stromphasenweise durch Überbrückungsabschnitte 44 miteinander verbunden. Entsprechend bildet die Platte 35f eine Überbrückungseinrichtung.

Ein auf die Platte 35f aufgesetzter Stromzähler lässt sich durch ein Vorhängeschloss arretieren, für dessen Bügel eine Öffnung 30f in einem Block 45 vorgesehen ist. Ferner sind eine Öffnung 32f für eine Steckplombe, eine Öffnung 31f für ein vorstehendes Steckschloss und eine Öffnung 46 für ein durch ein Spezialwerkzeug drehbares, von dem Block 45 vorstehendes Schraubelement gebildet. Die Arretierung eines auf die Platte 35f aufgesteckten und verschobenen Stromzählers kann also wahlweise auf verschiedene Weise erfolgen.

Eingriffsmulden 47 erlauben eine Verschiebung der Platte 35f mittels Finger oder Daumen.

## Patentansprüche

1. Zählerplatz für einen Stromzähler (6), der Einrichtungen (8,9,10;9a;1b,19,20; 1 c,9c;1 d,9d,25;35; 35f) zur Befestigung des Stromzählers (6) an dem Zählerplatz in einer für die Aufnahme des Zählers (6) vorgesehenen, von der Betriebsposition des Stromzählers (6) auf dem Zählerplatz entfernten Parkposition aufweist,
**dadurch gekennzeichnet**
**dass** Einrichtungen (30,31,32;33;13,15;30a,31 a,32a;21,22,30b;21 c,22c,30c;30d, 32d,34;42;30f,31 f,32f,45,46) zur Arretierung des Stromzählers (6) in der Parkposition durch ein Vorhänge- oder Steckschloss und/oder zur Plombierung des Stromzählers (6) in der Parkposition vorgesehen sind.

2. Zählerplatz nach Anspruch 1,
**dadurch gekennzeichnet,**
**dass** der Zählerplatz durch einen Adapter (1,2) gebildet ist, über welchen der Stromzähler (6) an einen anderen, zur Aufnahme eines anderen Stromzählers vorgesehenen Zählerplatz elektrisch und mechanisch koppelbar ist.

3. Zählerplatz nach Anspruch 1 oder 2,
**dadurch gekennzeichnet,**
**dass** der Stromzähler (6) sowohl in der Betriebsposition als auch in der Parkposition an den Zählerplatz mechanisch durch Hakenelemente (7), welche auf der dem Zählerplatz zugewandten Seite des Stromzählergehäuses angeordnet sind, koppelbar ist.

4. Zählerplatz nach einem der Ansprüche 1 bis 3,
**dadurch gekennzeichnet,**
**dass** sich die Einrichtungen (8,9,10;9a;1b,19,20;1c,9c;1d,9d,25;135; 35f) zur Befestigung des Stromzählers (6) an dem Zählerplatz aus ihrer Betriebsstellung, in der sie den Stromzähler (6) in der Parkposition halten, wenigstens teilweise entfernen lassen.

5. Zählerplatz nach einem der Ansprüche 1 bis 4,
**dadurch gekennzeichnet,**
**dass** die Einrichtungen (8,9,10;9a;1b,19,20;1c,9c;1d,9d,25;135; 35f) zur Befestigung des Stromzählers von einer Zählertragplatte (3) vorstehende Halteelemente (8) für den Stromzähler (6) umfassen.

6. Zählerplatz nach Anspruch 5,
**dadurch gekennzeichnet,**
**dass** die Halteelemente (8) von der Zählertragplatte (3) vorstehende Stege (9) umfassen.

7. Zählerplatz nach Anspruch 6,
**dadurch gekennzeichnet,**
**dass** mit den Stegen (9) Halteleisten (10) mit Öffnungen (11,12;24) für den Eingriff der Hakenelemente (7) des Stromzählers (6) verbunden sind.

8. Zählerplatz nach Anspruch 7,
**dadurch gekennzeichnet,**
**dass** die Halteleisten (10a) gegen die Stege (9a) oder die Stege gegen die Zählertragplatte verschwenkbar sind.

9. Zählerplatz nach Anspruch 8,
**dadurch gekennzeichnet,**
**dass** die Halteleiste (10a) bzw. der Steg über ein Filmscharnier (16) verschwenkbar ist.

10. Zählerplatz nach einem der Ansprüche 5 bis 9,
**dadurch gekennzeichnet,**
**dass** am Zählerplatz Einrichtungen zur Befestigung der Halteelemente entfernt von deren Betriebsstellung, in der sie den Stromzähler in der Parkposition halten, vorgesehen sind.

11. Zählerplatz nach einem der Ansprüche 3 bis 10,
**dadurch gekennzeichnet,**
**dass** der Stromzähler (6) durch die Hakenelemente (7) in der Parkposition in einer Richtung parallel zur Verschiebungsrichtung auf seiner Tragplatte beim Anschluss oder quer zu dieser Verschiebungsrichtung eingehakt ist.

12. Zählerplatz nach einem der Ansprüche 1 bis 11,
**dadurch gekennzeichnet,**
**dass** die Einrichtungen zur Befestigung des Stromzählers durch ein einstückiges, als Platte (35) oder U-Profil vorgesehenes Halteteil gebildet sind, welches in einer der Betriebsstellung des Stromzählers entsprechenden Position auf dem Zählerplatz anbringbar ist.

13. Zählerplatz nach Anspruch 12,
**dadurch gekennzeichnet,**
**dass** die Platte (35) anstelle des Stromzählers an den Zählerplatz in gleicher Weise wie der Stromzähler durch Hakenelemente (36) koppelbar ist.

14. Zählerplatz nach Anspruch 12 oder 13,
**dadurch gekennzeichnet,**
**dass** die Platte (35) wenigstens ein Mitnehmerelement (37) aufweist, das in Form und Anordnung einem Kontaktelement (5) des Stromzählers (6) entspricht.

15. Zählerplatz nach einem der Ansprüche 12 bis 14,
**dadurch gekennzeichnet,**
**dass** die Platte (35f) phasenweise durch Überbrückungen (44) verbundene Kontaktelemente (37f) entsprechend den Phasenkontaktelementen (5) des Stromzählers (6) aufweist.

16. Zählerplatz nach einem der Ansprüche 12 bis 15,
**dadurch gekennzeichnet,**
**dass** die Platte (35), vorzugsweise einstückig, mit einem gegen die Platte (35) beweglichen, in der auf die Tragplatte aufgesetzten Stellung der Platte den Stromzähler formschlüssig auf der Platte haltenden Sperrelement (40) verbunden ist.

17. Zählerplatz nach Anspruch 16,
**dadurch gekennzeichnet,**
**dass** das Sperrelement (40) mit der Platte (35) über ein Filmscharnier (38) verbunden ist.

18. Zählerplatz nach einem der Ansprüche 12 bis 17,
**dadurch gekennzeichnet,**
**dass** die Platte (35) durch ein Drehbefestigungselement (42) an der Zählertragplatte arretierbar ist.

19. Zählerplatz nach Anspruch 18,
**dadurch gekennzeichnet,**
**dass** das Drehbefestigungselement (42) über einen durch das Gehäuse des Stromzählers hindurchgeführten Arretierungsbolzen für den Stromzähler betätigbar ist.

20. Zählerplatz nach einem der Ansprüche 12 bis 19,
**dadurch gekennzeichnet,**
**dass** der Stromzähler auf der Platte (35) wahlweise auf verschiedene Weise arretierbar ist.

## Claims

1. Meter station for an electricity meter (6) which has devices (8, 9, 10; 9a; 1b, 19, 20; 1c, 9c; 1d, 9d, 25; 35; 35f) for fastening the electricity meter (6) to the meter station in a park position which is provided for accommodating the meter (6) and is remote from the operating position of the electricity meter (6) on the meter station,
**characterized**
**in that** devices (30, 31, 32; 33; 13, 15; 30a, 31a, 32a; 21, 22, 30b; 21c, 22c, 30c; 30d, 32d, 34; 42; 30f, 31f, 32f, 45, 46) are provided for locking the electricity meter (6) in the park position using a padlock or key lock and/or for sealing the electricity meter (6) in the park position.

2. Meter station according to Claim 1,
**characterized**
**in that** the meter station is formed by an adapter (1, 2) by means of which the electricity meter (6) can be electrically and mechanically coupled to another meter station which is provided for accommodating another electricity meter.

3. Meter station according to Claim 1 or 2,
**characterized**
**in that**, both in the operating position and in the park position, the electricity meter (6) can be mechanically coupled to the meter station by hook elements (7) which are arranged on that side of the electricity meter housing which faces the meter station.

4. Meter station according to one of Claims 1 to 3,
**characterized**
**in that** the devices (8, 9, 10; 9a; 1b, 19, 20; 1c, 9c; 1d, 9d, 25; 135; 35f) for fastening the electricity meter (6) to the meter station can be at least partially removed from their operating position in which they hold the electricity meter (6) in the park position.

5. Meter station according to one of Claims 1 to 4,
**characterized**
**in that** the devices (8, 9, 10; 9a; 1b, 19, 20; 1c, 9c; 1d, 9d, 25; 135; 35f) for fastening the electricity meter comprise holding elements (8) for the electricity meter (6) which project from a meter support plate (3).

6. Meter station according to Claim 5,
**characterized**
**in that** the holding elements (8) comprise webs (9) which project from the meter support plate (3).

7. Meter station according to Claim 6,
**characterized**
**in that** holding strips (10) with openings (11, 12; 24) for engagement of the hook elements (7) of the electricity meter (6) are connected to the webs (9).

8. Meter station according to Claim 7,
**characterized**
**in that** the holding strips (10a) can be pivoted towards the webs (9a) or the webs can be pivoted towards the meter support plate.

9. Meter station according to Claim 8,
**characterized**
**in that** the holding strip (10a) or the web can be pivoted by means of a film hinge (16).

10. Meter station according to one of Claims 5 to 9,
**characterized**
**in that** devices for fastening the holding elements are provided on the meter station remote from their operating position in which they hold the electricity meter in the park position.

11. Meter station according to one of Claims 3 to 10,
**characterized**
**in that** the electricity meter (6) is hooked by the hook elements (7) in the park position in a direction parallel to the movement direction on its support plate during connection or transverse to the said movement direction.

12. Meter station according to one of Claims 1 to 11,
**characterized**
**in that** the devices for fastening the electricity meter are formed by an integral holding part which is provided as a plate (35) or U-profile and can be fitted on the meter station in a position which corresponds to the operating position of the electricity meter.

13. Meter station according to Claim 12,
**characterized**
**in that** the plate (35), instead of the electricity meter, can be coupled to the meter station in the same way as the electricity meter by hook elements (36).

14. Meter station according to Claim 12 or 13,
**characterized**
**in that** the plate (35) has at least one driver element (37) which corresponds to a contact element (5) of the electricity meter (6) in terms of shape and arrangement.

15. Meter station according to one of Claims 12 to 14,
**characterized**
**in that** the plate (35f) has contact elements (37f) which are connected in phases by bridging means (44) in a manner corresponding to the phase contact elements (5) of the electricity meter (6).

16. Meter station according to one of Claims 12 to 15,
**characterized**
**in that** the plate (35) is connected, preferably integrally, to a blocking element (40) which can be moved towards the plate (35) and holds the electricity meter in an interlocking manner on the plate in the position in which the plate is mounted on the support plate.

17. Meter station according to Claim 16,
**characterized**
**in that** the blocking element (40) is connected to the plate (35) by means of a film hinge (38).

18. Meter station according to one of Claims 12 to 17,
**characterized**
**in that** the plate (35) can be locked to the meter support plate by a rotary fastening element (42).

19. Meter station according to Claim 18,
**characterized**
**in that** the rotary fastening element (42) can be operated by means of a locking pin for the electricity meter which is routed through the housing of the electricity meter.

20. Meter station according to one of Claims 12 to 19,
**characterized**
**in that** the electricity meter can be locked on the plate (35) selectively in various ways.

## Revendications

1. Porte-compteur pour un compteur électrique (6), qui comprend des organes (8, 9, 10 ; 9a ; 1b, 19, 20 ; 1c, 9c ; 1d, 9d, 25 ; 35 ; 35f) pour la fixation du compteur électrique (6) sur le porte-compteur dans une position de rangement prévue pour la réception du compteur (6) et éloignée de la position de service du compteur électrique (6) sur le porte-compteur,
**caractérisé en ce qu'**il est prévu des moyens (30, 31, 32 ; 33 ; 13, 15 ; 30a, 31a, 32a ; 21, 22, 30b ; 21c, 22c, 30c ; 30d, 32d, 34 ; 42 ; 30f, 31f, 32f, 45, 46) pour arrêter le compteur électrique (6) dans la position de rangement par un cadenas ou un verrou enfichable et/ou pour plomber le compteur électrique (6) dans la position de rangement.

2. Porte-compteur selon la revendication 1,
**caractérisé en ce que** le porte-compteur est formé par un adaptateur (1, 2) au moyen duquel le compteur électrique (6) peut être accouplé électriquement et mécaniquement sur un autre porte-compteur prévu pour la réception d'un autre compteur électrique.

3. Porte-compteur selon la revendication 1 ou 2,
**caractérisé en ce que** le compteur électrique (6) peut être accouplé mécaniquement au porte-compteur aussi bien dans la position de service que dans la position de rangement par des éléments à crochet (7) qui sont agencés sur le côté du boîtier de compteur tourné vers le porte-compteur.

4. Porte-compteur selon l'une des revendications 1 à 3,
**caractérisé en ce que** les organes (8, 9, 10 ; 9a ; 1b, 19, 20 ; 1c, 9c ; 1d, 9d, 25 ; 35 ; 35f) pour la fixation du compteur électrique (6) sur le porte-compteur peuvent être au moins partiellement enlevés hors de leur position de service dans laquelle ils maintiennent le compteur électrique (6) dans la position de rangement.

5. Porte-compteur selon l'une des revendications 1 à 4,
**caractérisé en ce que** les organes (8, 9, 10 ; 9a ; 1b, 19, 20 ; 1c, 9c ; 1d, 9d, 25 ; 35 ; 35f) pour la fixation du compteur électrique comprennent des éléments de maintien (8) pour le compteur électrique (6), qui dépassent d'une plaque-support (3) pour le compteur.

6. Porte-compteur selon la revendication 5,
**caractérisé en ce que** les éléments de maintien (8) comprennent des barrettes (9) qui dépassent de la plaque-support (3) pour le compteur.

7. Porte-compteur selon la revendication 6,
**caractérisé en ce que** des languettes de maintien (10) avec des ouvertures (11, 12 ; 24) pour l'engagement des éléments à crochet (7) du compteur électrique (6) sont reliées avec les barrettes (9).

8. Porte-compteur selon la revendication 7,
**caractérisé en ce que** les languettes de maintien (10a) sont capables de pivoter par rapport aux barrettes (9a), ou **en ce que** les barrettes sont capables de pivoter par rapport à la plaque-support pour le compteur.

9. Porte-compteur selon la revendication 8,
**caractérisé en ce que** la languette de maintien (10a) ou respectivement la barrette est capable de pivoter via une charnière à bande (16).

10. Porte-compteur selon l'une des revendications 5 à 9,
**caractérisé en ce qu'**il est prévu sur le porte-compteur des moyens pour la fixation des éléments de maintien à distance de leur position de service dans laquelle ils maintiennent le compteur électrique dans la position de rangement.

11. Porte-compteur selon l'une des revendications 3 à 10,
**caractérisé en ce que** le compteur électrique (6) est accroché par les éléments à crochet (7) dans la position de rangement dans une direction parallèle à la direction de déplacement sur sa plaque-support lors du raccordement ou transversalement à cette direction de déplacement.

12. Porte-compteur selon l'une des revendications 1 à 11,
**caractérisé en ce que** les organes pour la fixation du compteur électrique sont formés par une partie de maintien d'un seul tenant, prévue sous la forme de plaque (35) ou de profilé en U, qui peut être amenée sur le porte-compteur dans une position qui correspond à la position de service du compteur électrique.

13. Porte-compteur selon la revendication 12,
**caractérisé en ce que** la plaque (35) est susceptible d'être accouplée à la place du compteur électrique sur le porte-compteur de la même manière que le compteur électrique par des éléments à crochet (36).

14. Porte-compteur selon la revendication 12 ou 13,
**caractérisé en ce que** la plaque (35) comprend au moins un élément d'entraînement (37) qui correspond quant à sa forme et son agencement à un élément de contact (5) du compteur électrique (6).

15. Porte-compteur selon l'une des revendications 12 à 14,
**caractérisé en ce que** la plaque (35f) comprend des éléments de contact (37f), connectés par phases par des cavaliers de pontage (44), en correspondance des éléments de contact de phase (5) du compteur électrique (6).

16. Porte-compteur selon l'une des revendications 12 à 15,
**caractérisé en ce que** la plaque (35) est reliée, de préférence d'un seul tenant, à un élément de blocage (40), mobile par rapport à la plaque (35) et maintenant le compteur électrique par coopération de formes sur la plaque, dans la position de la plaque posée sur la plaque-support.

17. Porte-compteur selon la revendication 16,
**caractérisé en ce que** l'élément de blocage (40) est relié à la plaque (35) via une charnière à bande (38).

18. Porte-compteur selon l'une des revendications 12 à 17,
**caractérisé en ce que** la plaque (35) est susceptible d'être arrêtée sur la plaque-support via un élément de fixation rotatif (42).

19. Porte-compteur selon la revendication 18,
**caractérisé en ce que** l'élément de fixation rotatif (42) est susceptible d'être actionné via un goujon d'arrêt, passé à travers le boîtier du compteur électrique, pour le compteur électrique.

20. Porte-compteur selon l'une des revendications 12 à 19,
**caractérisé en ce que** le comptoir électrique est susceptible d'être arrêté sélectivement de diverses manières sur la plaque (35).
